# EUROPEAN PATENT APPLICATION

(11) **EP 0 982 532 A2**
(43) Date of publication of application: **01.03.2000**
(21) Application number: 99116509.3
(22) Date of filing: 23.08.1999
(51) Int. Cl.: F21K 7/00

(54) **A lamp comprising a light emitting diode**

(30) Priority: 21.08.1998 JP 23561098
(71) Applicant: Stanley Electric Co., Ltd., Meguro-ku Tokyo 153-8636 (JP)
(72) Inventor: Toshiyuki, Kondo, Tokyo 153-8638 (JP); Yoshifumi, Kawaguchi, Tokyo 153-8638 (JP); Tadashi, Nomura, Yokohama-shi, Kanagawa-ken 225-0014 (JP); Nobumichi, Aita, Yokohama-shi, Kanagawa-ken 225-0014 (JP)
(74) Representative: Wagner, Karl H., Dipl.-Ing.

(57) **Abstract**

An LED lamp (1) comprising a resin case (3) in which an LED chip (2) is sealed, and the resin case (3) is enlarged only in diameter to substantially have a plate form, and an illuminating surface (3a) of this resin case (3) is a lens cut surface (3a) which is combination of several planes (3d), and the back surface (3b) of the resin case (3) has reflecting function. Another type of the LED lamp (1) has a resin case (3) comprising two separate portions, one is a main portion (31) sealed LED chip (2) and the other is an adapter portion (32) having a lens cut surface (3a). There is a space (34) between the main portion (31) and the adapter portion (32), and the space (34) is injected with transparent liquid or gel material if needed.

## Description

### BACKGROUND OF THE INVENTION

### Field of the Invention

This invention relates to an LED LAMP, a lamp including a light emitting diode as a light source, and more particularly to a composition and method of a light emitting diode lamp whose emitting area is enlarged in order to be used as a light source for an automobile lamp.

### Discussion of the Related Art

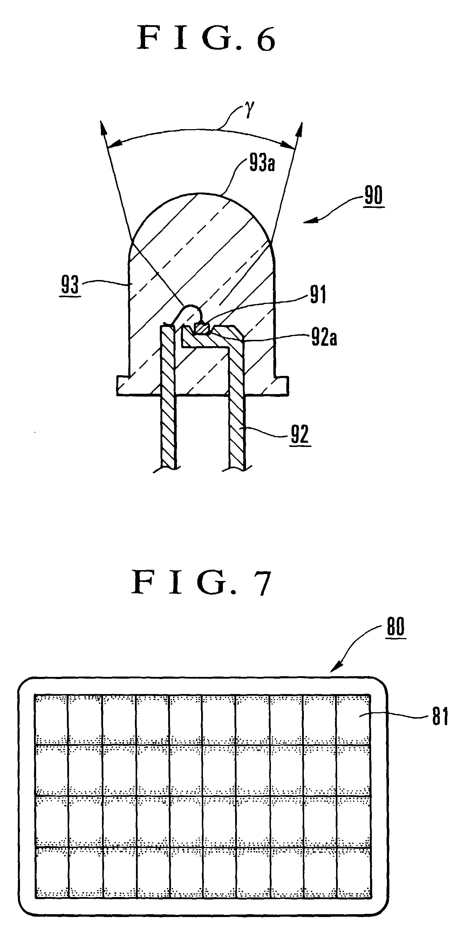

Fig.6 illustrates a conventional LED lamp 90, wherein an LED chip 91 is mounted on a horn portion 92a of a lead frame 92. The horn portion 92a has a reflecting function and directs the emitted light of the LED lamp 90 to the predetermined directions, and the chip 91 is entirely covered by a molded case 93 made of transparent resin.

The object of the molded case 93 used to cover the LED chip 91, is to improve the resistance against humidity and to give the appropriate illumination angle to the light emitted from the LED chip 91 and the light reflected by the horn portion 92a. Accordingly, the top portion 93a of the molded case 93 is formed to be a convex lens, having an illumination angle γ of approximately 30-40 degrees.

Since the LED chip 91 is sealed in the molded case 93, the LED chip 91 and the wiring are exposed to stress caused by the difference of the heat expansion coefficient between the LED chip 91 and the molded case 93, and other factors. Therefore, the appropriate diameter of the molded case 93 is approximately less than 5 millimeters.

The conventional LED lamp 90 has the following problems. When it is used as a light source of a tail lamp 80 or the like, which requires a uniform area-lighting property, sufficient numbers of the LED lamps 90 are disposed in the form of a matrix to obtain a predetermined brightness. However as shown in Fig. 7, a surface of a lens 81 of the tail lamp 80 seems to have patches and does not have uniform brightness to the extent of a greatly deteriorating appearance of the tail lamp 80 because the light emitting area is small and also the illuminating angle γ is small.

The problem that the tail lamp 80 does not have uniform brightness is solved by applying a smaller pitch when the LED lamp 90 is disposed in the form of a matrix or by increasing the number of LED lamps 90 disposed in the tail lamp 80. Nevertheless, the problem of higher cost may occur by the increased number of the LED lamps. Furthermore, a rapid temperature increase occurs in the tail lamp 80 and the light emitting efficiency of the LED lamp 90 decreases, such that the consumption of electric power increases at a higher rate than the increase in the number of the adopted LED lamps. Additionally, the life of the lamp becomes shorter.

### SUMMARY OF THE INVENTION

The present invention is directed to an LED lamp that substantially obviates one or more of the above problems due to the limitation and disadvantages of the conventional lamps.

It is an object of the invention to enlarge the diameter only, of a resin case surrounding the LED lamp to get a larger illuminating surface for the lamp.

It is another object of the invention to decrease patches and to get uniform brightness when the LED lamps are used to form a matrix to get larger area-lighting.

According to the present invention, the above objects are achieved by providing an LED lamp comprising a resin case, whose diameter only, is enlarged to make substantially a plate form. The illuminating surface of this resin case is a lens cut surface, which is a combination of several planes, with the back surface of the resin case having a reflecting function.

### BRIEF DESCRIPTION OF THE DRAWINGS

The accompanying drawings, which are included to provide a further understanding of the invention, illustrate embodiments of the invention and together with the description serve to outline the principles of the invention.
Fig. 1 is a cross sectional view of an LED lamp according to the first preferred embodiment of the present invention.
Fig. 2 is a front view of an LED lamp according to the first preferred embodiment of the present invention.
Fig. 3 is a cross sectional view of an LED lamp according to a second preferred embodiment of the present invention.
Fig. 4 is a front view of an LED lamp according to a third preferred embodiment of the present invention.
Fig. 5 is a cross sectional view of an LED lamp according to a fourth preferred embodiment of the present invention.
Fig. 6 is a cross sectional view of a conventional LED lamp.
Fig. 7 is an illustration to explain the design of a conventional LED lamp used as a light source for automobile lamps.

### DETAILED DESCRIPTION OF THE PREFERRED EMBODIMENT

The preferred embodiments of the present invention will be described with reference to the drawing.

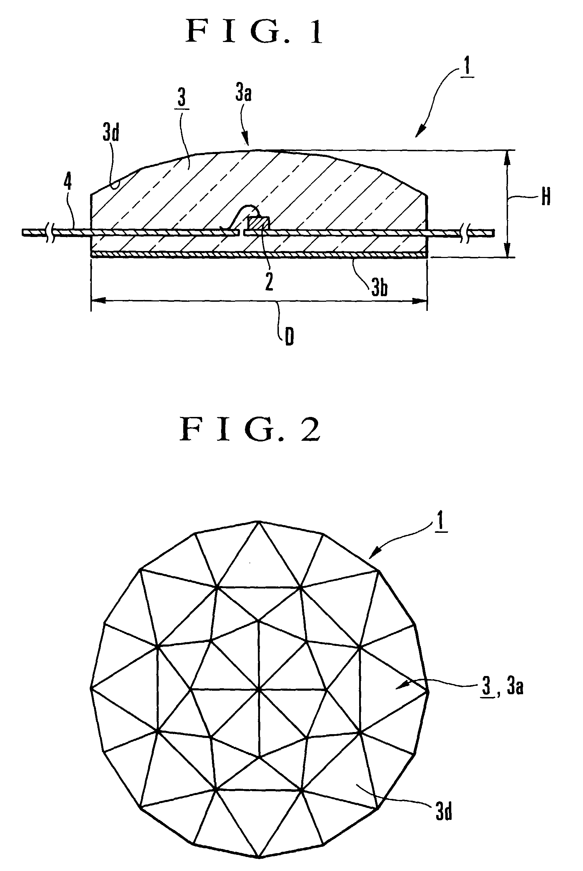

The first preferred embodiment of the present invention is shown in Figs. 1 and 2. An LED lamp 1 as shown in Fig. 1 and Fig. 2 comprises, similar to a conventional LED lamp 90, an LED chip 2 sealed in a resin case 3, and a lead frame 4 on which the LED chip 2 is mounted.

In this embodiment, the resin case 3 is formed to have substantially the same height H as a conventional LED lamp which is typically about 3 - 10 millimeters. The length of the resin case 3 is enlarged in a diameter direction, i.e. the diameter of the resin case 3 is enlarged. Whereas the diameter of the conventional resin case is 2 - 5 millimeters, the resin case 3 has a three to five times larger diameter (D) which is 10 - 25 millimeters.

As for the resin case 3 described in the above as compared to the conventional resin case 93, the height H of the resin case 3 is not changed but the diameter of the resin case 3 is enlarged to substantially have a plate form. This means that the amount of resin used for the formation of the resin case 3 is increased in the portions of the resin case 3 which are away from the LED chip 2 in the diameter direction. Accordingly, although the amount of resin used for the formation of the resin case 3 increases, the stress put on the LED chip 2 is not increased very much. The form of the resin case 3 enables the prevention of damage to the LED chip 2 caused by the stress of the resin.

Since the diameter (D) of the resin case 3 is larger than the height (H) of the resin case 3, it is impossible to make a design as shown in Fig.6 where the top portion of the cylinder has a projection lens in the form of a hemisphere. Therefore, in the resin case 3, a surface 3a from which emitted light from the LED chip 2 exits, has prismatic cuts, and a back surface 3b opposite to surface 3a (also called the lens cut surface or light illuminating surface) has a reflecting function.

The lens cut surface 3a is a convex surface like a jewel, and is a combination of several planes 3d as shown in Fig. 2. The back surface 3b is a plane having the reflecting function due to an aluminum deposition through vacuum evaporation applied or the like. In order to form the resin case 3, a similar way to the conventional one is used involving injection molding using epoxy resin.

The following explanation is with regard to the operation and advantages of the LED lamp 1 of the design of the invention described in the above. First, when the LED lamp 1 is not turned on, since the patterns on the lens cut surface 3a are reflected by the back surface 3b and pass the lens cut surface 3a again toward the outside of the LED lamp 1, the lens cut surface 3a looks like a sparkling jewel.

In addition, when the lamp is turned on, the light emitted in the direction of the diameter from the LED chip 2 becomes incident to the lens cut surface 3a at a comparatively large angle. The lens cut surface 3a totally reflects some of the light rays due to the large angle of incidence and the light rays reach the back surface 3b.

The lens cut surface 3a is formed by a combination of planes 3d having various angles relative to the back surface 3b and the light rays reflected within the resin case 3 travel in various directions. If the surface 3a where the light ray impinges does not fulfil the condition of total reflection, the light illuminates the outside of the lamp. This illumination is performed from substantially all flat planes 3d. When the LED lamp 1 is turned on, all the lens cut surfaces 3a sparkle with the color of the light emitted from the LED chip 2 and look like jewels.

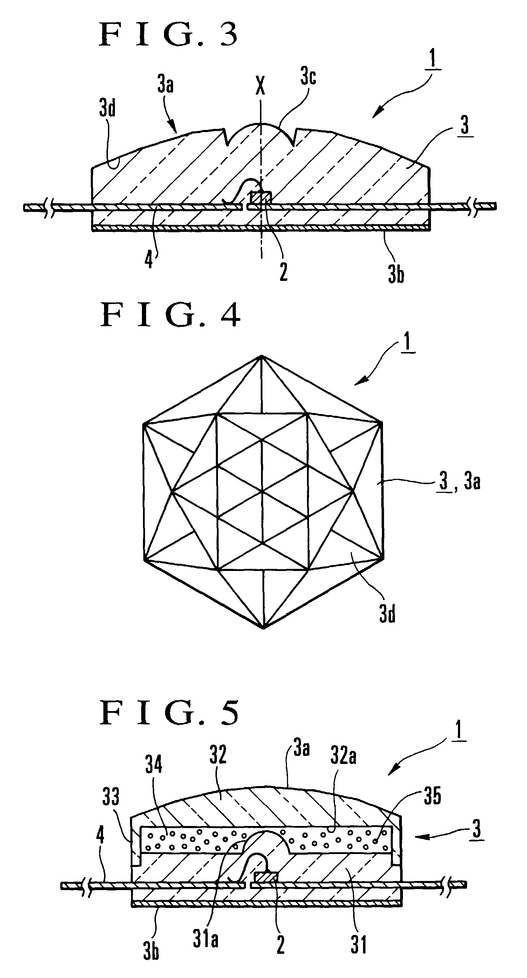

It is noted that the back surface 3b, also called reflecting surface 3b may not be flat or planar as is shown in Fig. 3 and 5. The back surface 3b might comprise on an otherwise flat plane a convex cone or a plurality of cones. Said cones could have the shape of diamonds. The back surface 3b could also be convex, or could be provided with a plurality of convex shaped elements. The back surface could also be provided with a dent or a plurality of dents. The just described modifications of the back surface 3b would give the LED lamp 1, if it is turned off, a more aesthetic and variable appearance.

If the reflecting surface 3b is just flat, as shown for instance in Fig. 3, there is in substance only one direction into which the light is reflected. This could be called a monotonous reflection which is less desirable than a complicated reflection.

Moreover, if the lens cut surface 3a has the appropriate number of planes 3d with the appropriate tilt angles, then, when the LED lamps 1 are disposed in the form of a matrix, said lamps are suitable to be used as light sources of a lamp 80 for an automobile. When said lamps are turned on, the illuminating areas of neighboring LED lamps 1 can be designed to overlap. Thus, the lens surface of the lamp for an automobile does not have patches and it has uniform brightness.

Fig. 3 illustrates a second preferred embodiment of this invention. The object of the above first preferred embodiment is illuminating the light uniformly and widely as much as possible from the LED chip 2 through the lens cut surface 3a. Because of the above object, the luminous intensity may not be high enough for the lamp 80, which requires high luminosity when the lamp is turned on.

This second preferred embodiment in Fig. 3 is improved for the above use. A convex lens portion 3c is formed on the line of a center axis X of the LED chip 2 in the resin case 3 formed similar to the first preferred embodiment. The light emitted from the LED chip 2 has along the axis X a comparatively small irradiation of, for example, 30 degrees.

Accordingly, the LED lamp 1 in this second preferred embodiment has comparatively high center luminous intensity and illuminates light with a wide illuminating angle. The LED lamp 1 has high enough luminous intensity for use as a light source for a stop lamp or the like. When the LED lamps 1 are used as the lamp for an automobile, the lens surface does not have patches and has uniform brightness. The second preferred embodiment has the same design except the above mentioned convex lens portion. It otherwise functions and has the same effects as the first preferred embodiment.

Fig. 4 illustrates a third preferred embodiment of this invention. As described in the above first embodiment, this LED lamp 1 of the invention has a beautiful appearance both when it is turned on as well when it is as off. Accordingly, the resin case 3 (lens cut surface 3a) of this LED lamp 1 can also be used as the lighting surface (i.e. an outer lens) of a lamp for an automobile.

The lamp 1 of the third embodiment is formed to suit the condition of use. The form of the LED lamp 1 seen from the front side is made into a polygon to improve the appearance of the plural LED lamps 1 when arranged in a matrix. Although the form of the LED lamp 1 seen from the front side can be any polygon with any number of angles such as a triangle, a quadrilateral or a pentagon, when the LED lamps 1 are formed in lines, the form of a quadrilateral or hexagon is better to get a beautiful appearance.

Fig. 5 illustrates the fourth preferred embodiment of this invention. This fourth preferred embodiment is formed to realize a wider utility of the LED lamp 1. As stated in the above from the first to the third embodiment, this LED lamp 1 has many embodiments. Especially, the designed lens cut surface like the third embodiment may have many kinds of designed surfaces because of the many requirements of the customers.

This fourth embodiment of the resin case 3 comprises a main portion 31, a sealed LED chip 2 and an adapter portion 32 with a lens cut surface 3a. An engagement portion 33 is formed on the periphery of the main portion 31 and the main portion 31 is attached to an adapter portion 32 with the engagement portion 33. Accordingly, the efficiency of the production process is improved, because the appropriate forms and specific characters of the adapter portion 32, which fit to the requirements of the customers, can be prepared.

When the main portion 31 and the adapter portion 32 are engaged with the engagement portion 33, they cannot be engaged very closely and there is a space 34 between the main portion 31 and the adapter portion 32. The surface of the adapter portion 32 facing the space 34 can be formed as a flat surface 32a and the surface of the main portion 31 facing to the space 34 can be formed like a lens 31a corresponding to the LED chip 2.

When the main portion 31 and the adapter portion 32 are engaged, the illuminating characteristic is very close to the second preferred embodiment due to the form of the lens 31a. If the space between lens 31a and surface 32a is filled up with transparent materials like silicon gel or the like, the function of the lens 31a is weakened by the refractive index of the transparent material 35. The illuminating characteristic becomes very close to that of the first preferred embodiment. Accordingly, the fourth embodiment becomes more practical.

In this fourth preferred embodiment, the reflecting surface 3b is formed at the back surface of the main portion 31. If the reflecting surface is formed at the front surface omitting the lens 31a, the effect is the same as for the above case. The same action and effect can be achieved by using an LED lamp available on the market as the main portion 31 and forming only the adapter portion 32.

The length of the resin case 3 of this invention is enlarged in diameter to make substantially a plate form. The illuminating front surface of this resin case 3 is a combination of several planes 3d to form a lens cut surface, whereas the back surface of the resin case 3 has a reflecting function. When the several LED lamps are disposed in lines to create the area-lighting surface, the conventional LED lamp 90 has patches and does not have uniform brightness because of a small area-lighting and a small illumination angle. By enlarging the resin case in the direction of diameter and giving the back surface a reflecting function, the illuminating area becomes larger and the illuminating angle increases without putting so much stress on the LED chip 2. The disposition of the LED lamp 3 is greatly improved.

By separating the main portion 31 which seals LED chip 2 and the adapter portion 32 comprising the lens cut surface and reflecting surface, several designs are promptly and easily created by means of exchanging the adapter portion 32. The utility of the LED lamp 3 is greatly improved, and the variety of production and rationalizing of the production are possible.

To sum it up, according to the invention, D is larger than H. Preferably the range for D is between H and 5H. Optimally, D is about 3H.

Furthermore, with the lens cut surface 3a being a combination of many inclined flat planes or surfaces 3d, the light emitted from this LED chip 2 diffuses in a wide angle range. Accordingly, if the LED lamps 1 are mounted in a form of a matrix in the automobile lamp 80, the light from each LED lamp 1 overlaps with the light from other lamps. Thus, it is possible to get uniform illumination, and the automobile lamp does not have patches on its lens surface.

## Claims

1. A lamp (1) comprising a light emitting diode, in which an LED chip (2) is sealed in a resin case (3) having a diameter (D);
said resin case (3) being enlarged in diameter (D) direction to have substantially a plate form;
said resin case (3) having a light illuminating surface (3a) formed as a combination of several planes (3d) to be a lens cut surface (3a); and
said resin case (3) having a back surface (3b) with a reflecting function.

2. The LED lamp (1) of the claim 1, wherein the light illuminating surface (3a) of the resin case (3) has a convex lens portion (3c) above the sealed LED chip (2).

3. The LED lamp (1) of the claim 1 or 2, whose front view seen from the light illuminating side is in the form of a polygon.

4. The LED lamp (1) of the claim 1,2 or 3, wherein the resin case (3) comprises two separate portions, one is a main portion (31) sealed LED chip (2) and the other is an adapter portion (32) having lens cut surface (3a).

5. The LED lamp (1) of claim 4, wherein there is a space (34) between the main portion (31) and the adapter portion (32), and the space (34) is injected with transparent liquid or gel materials if needed.
